# EUROPEAN PATENT APPLICATION

(11) **EP 4 704 267 A2**
(43) Date of publication of application: **04.03.2026**
(21) Application number: 25193083.0
(22) Date of filing: 31.07.2025
(51) Int. Cl.: H01S 5/02345, H01S 5/40, H01S 5/02253, H01S 5/02255, H01S 5/02257, H01S 5/02315, H01S 5/024, H01S 5/042, H01S 5/10

(54) **LIGHT-EMITTING DEVICE**

(30) Priority: 27.08.2024 JP 2024145039; 04.06.2025 JP 2025093653
(71) Applicant: NICHIA CORPORATION, Anan-shi, Tokushima 774-8601 (JP)
(72) Inventor: ENOMOTO, Kiyoshi, Anan-shi, Tokushima, 774-8601 (JP); YANO, Norikazu, Anan-shi, Tokushima, 774-8601 (JP)
(74) Representative: Betten & Resch

(57) **Abstract**

A light-emitting device includes a plurality of semiconductor laser elements including a first semiconductor laser element and a second semiconductor laser element, each of the plurality of semiconductor laser elements having an an upper surface and a light-emitting surface; a plurality of protective elements including a first protective element configured to protect the first semiconductor laser element and a second protective element configured to protect the second semiconductor laser element; and a plurality of wires including a first wire joined to the first protective element and a second wire joined to the second protective element, the plurality of wires being electrically connected to the plurality of semiconductor laser elements and the plurality of protective elements. The first wire is not joined to the first semiconductor laser element, and the second wire is joined to the upper surface of the second semiconductor laser element.

## Description

### BACKGROUND OF INVENTION

### Technical Field

The present invention relates to a light-emitting device.

### Background Art

Japanese Patent Publication No. 2023-88082A discloses a light-emitting device in which a plurality of light-emitting elements and a plurality of protective elements are disposed on the upper surface of a submount, and these elements are electrically connected to each other by a plurality of wires.

### SUMMARY OF INVENTION

According to one aspect of the invention disclosed in the present specification, wiring resistance can be reduced.

According to another aspect of the invention disclosed in the present specification, contact between wires can be easily avoided.

According to even another aspect of the invention disclosed in the present specification, wires can be stably connected while a plurality of semiconductor laser elements are densely arranged.

According to some aspects of the invention disclosed in the present specification, a plurality of problems among those described above can be solved in a combined manner.

A light-emitting device according to one embodiment of the present disclosure includes a plurality of semiconductor laser elements including a first semiconductor laser element and a second semiconductor laser element, each of the plurality of semiconductor laser elements having an an upper surface and a light-emitting surface; a plurality of protective elements including a first protective element configured to protect the first semiconductor laser element and a second protective element configured to protect the second semiconductor laser element; and a plurality of wires including a first wire joined to the first protective element and a second wire joined to the second protective element, the plurality of wires being electrically connected to the plurality of semiconductor laser elements and the plurality of protective elements. The first wire is not joined to the first semiconductor laser element, and the second wire is joined to the upper surface of the second semiconductor laser element.

In at least one of one or more inventions disclosed in the embodiments, wiring resistance can be reduced.

### BRIEF DESCRIPTION OF DRAWINGS

FIG. 1 is a schematic perspective view of a light-emitting device according to some embodiments.
FIG. 2 is a schematic side view of the light-emitting device according to some embodiments.
FIG. 3 is a schematic top view of the light-emitting device according to some embodiments.
FIG. 4 is a schematic sectional view of the light-emitting device according to some embodiments taken along line IV-IV of FIG. 3.
FIG. 5 is a schematic top view illustrating an internal structure of a light-emitting device according to the first embodiment.
FIG. 6A is a schematic enlarged view for describing an aspect of wire connection of the light-emitting device according to the first embodiment.
FIG. 6B is a first schematic supplementary diagram for describing an aspect of wire connection of the light-emitting device according to the first embodiment.
FIG. 6C is a second schematic supplementary diagram for describing an aspect of wire connection of the light-emitting device according to the first embodiment.
FIG. 7 is a schematic sectional view of a package according to some embodiments.
FIG. 8 is a schematic top view of a base according to some embodiments.
FIG. 9 is a schematic bottom view of the base according to some embodiments.
FIG. 10 is a schematic sectional view of the base according to some embodiments.
FIG. 11 is a schematic view of a semiconductor laser element and a protective element disposed on a submount.
FIG. 12 is a schematic top view illustrating an internal structure of a light-emitting device according to a second embodiment.
FIG. 13 is a schematic enlarged view for describing an aspect of wire connection of the light-emitting device according to the second embodiment.

### DETAILED DESCRIPTION OF EMBODIMENTS

In the present specification or the claims, polygons such as triangles and quadrangles, including shapes in which the corners of the polygon are rounded, beveled, chamfered, or coved, are referred to as polygons. A shape obtained by processing not only the corners (ends of a side) but also an intermediate portion of the side is similarly referred to as a polygon. That is, a shape that is partially processed while remaining a polygon shape as a base is included in the interpretation of "polygon" described in the present specification and the claims.

The same applies not only to polygons but also to words representing specific shapes such as trapezoids, circles, protrusions, and recesses. The same applies when dealing with each side forming that shape. That is, even if processing is performed on a corner or an intermediate portion of a certain side, the interpretation of "side" includes the processed portion. When a "polygon" or "side" not partially processed is to be distinguished from a processed shape, "exact" will be added to the description as in, for example, "exact quadrangle".

Further, in the present specification or the claims, descriptions such as upper and lower (upward/downward), left and right, surface and reverse, front and back (forward/backward), and near and far are used merely to describe the relative relationship of positions, orientations, and directions, and the expressions do not necessarily match an actual relationship at the time of use.

In the drawings, directions such as an X direction, a Y direction, and a Z direction may be indicated by using arrows. The directions of the arrows are consistent across multiple drawings of the same embodiment. In addition, in the drawings, the directions of the arrows marked with X, Y, and Z are the positive directions, and the opposite directions are the negative directions. For example, the direction marked with X at the tip of the arrow is the X direction and the positive direction. In the present specification, the direction that is the X direction and is the positive direction will be referred to as the "positive direction of X" and the direction opposite to this will be referred to as the "negative direction of X". The term "X direction" includes both the positive direction and the negative direction. The same applies to the Y direction and the Z direction.

In addition, in the present specification, when a certain object is specified as "one or more" and the object is described, an embodiment in which the object is one and an embodiment in which the object is plural are collectively described. Thus, a description specified as "one or more" supports every case of an embodiment including one or more objects, an embodiment including at least one object, and an embodiment including a plurality of objects.

In addition, in the present specification, the description illustrating "one or each" object is a description summarizing a description of one object in an embodiment including the one object, a description of one object in an embodiment including a plurality of objects, and a description of each of a plurality of objects in an embodiment including the plurality of objects. Thus, the description illustrating "one or each" object supports every case of an embodiment including one object in which the one object satisfies the described content, an embodiment including a plurality of objects in which, among these objects, at least one of the objects satisfies the described content, and an embodiment including a plurality of objects in which each of these plurality of objects satisfies the described content, and an embodiment including one or more objects in which all of the objects satisfy the described content.

The term "member" or "portion" may be used to describe, for example, a component in the present specification. The term "member" refers to an object physically treated alone. The object physically treated alone can be an object treated as one part in a manufacturing process. Meanwhile, the term "portion" refers to an object that need not be physically treated alone. For example, the term "portion" is used when part of one member is partially considered, or a plurality of members are collectively considered as one object.

The distinction between "member" and "portion" described above does not indicate an intention to consciously limit the scope of right in interpretation of the doctrine of equivalents. That is, even when a component described as "member" is present in the claims, this does not mean that the applicant recognizes that physically treating the component alone is essential in the application of the present invention.

In the present specification or the claims, when a plurality of components are present and these components are to be indicated separately, the components may be distinguished by adding the terms "first" and "second" at the beginning of the names of the components. Objects to be distinguished may differ between the present specification and the claims. Thus, even when a component in the claims is given the same term as that in the present specification, the object identified by that component is not the same across the present specification and the claims in some cases.

For example, when components distinguished by being termed "first", "second", and "third" are present in the present specification, and when components given the terms "first" and "third" in the present specification are described in the claims, these components may be distinguished by being denoted as "first" and "second" in the claims for ease of understanding. In this case, the components denoted as "first" and "second" in the claims refer to the components termed "first" and "third" in the present specification, respectively. This rule applies to not only components but also other objects in a reasonable and flexible manner.

An embodiment for implementing the present invention will be described below. A specific embodiment for implementing the present invention will be described below with reference to the drawings. An embodiment for implementing the present invention is not limited to the specific embodiment. That is, the embodiment illustrated by the drawings is not the only form in which the present invention is implemented. Sizes and positional relationships of members illustrated in each of the drawings may sometimes be exaggerated in order to facilitate understanding.

### First Embodiment

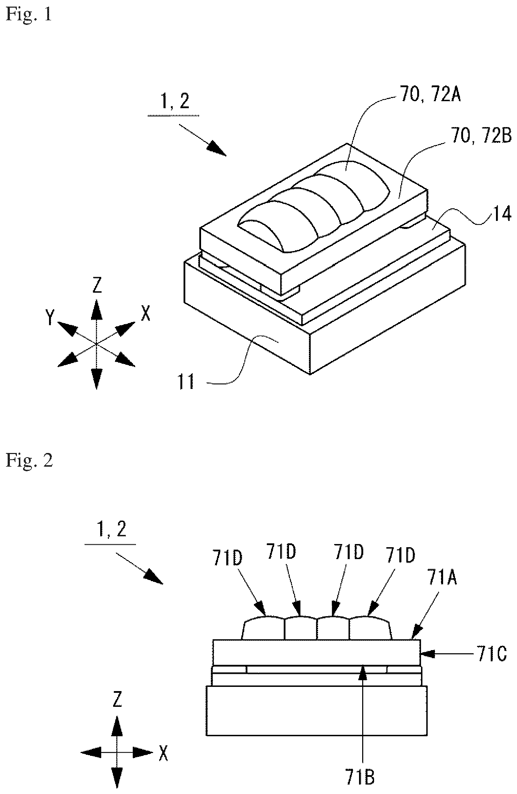

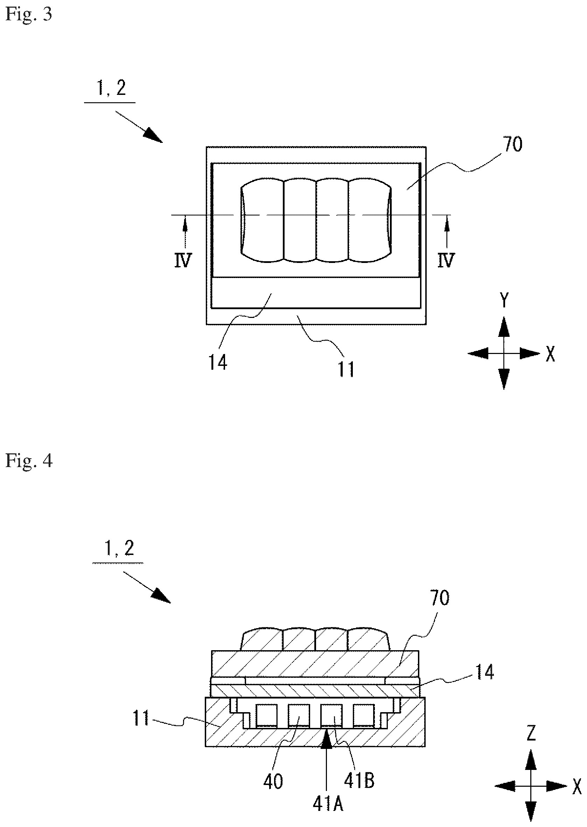

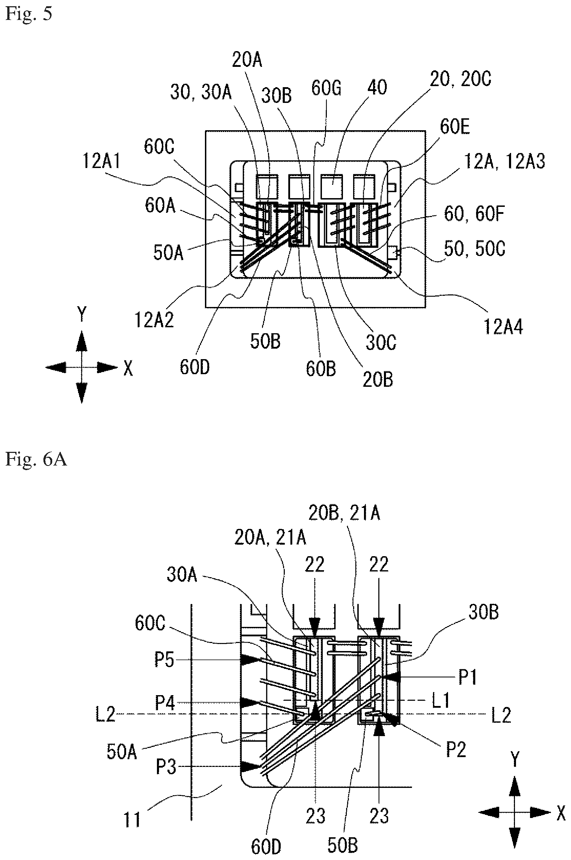

A light-emitting device 1 according to a first embodiment will now be described. FIGS. 1 to 11 are drawings for explaining an exemplary form of the light-emitting device 1. FIG. 1 is a schematic perspective view of the light-emitting device 1. FIG. 2 is a schematic side view of the light-emitting device 1. FIG. 3 is a schematic top view of the light-emitting device 1. FIG. 4 is a schematic sectional view of the light-emitting device 1 taken along line IV-IV of FIG. 3. FIG. 5 is a schematic top view illustrating an internal structure of the light-emitting device 1. FIG. 6A is a schematic enlarged view for describing an aspect of wire connection of the light-emitting device 1.

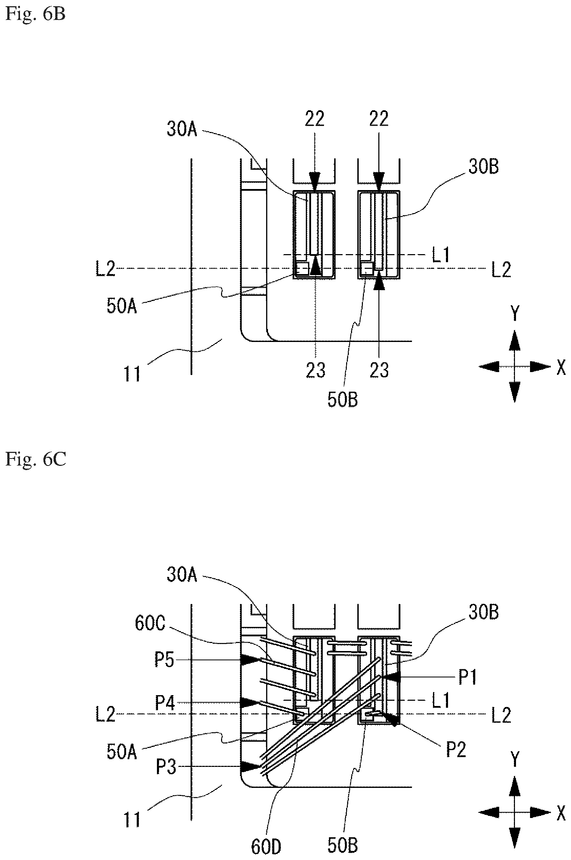

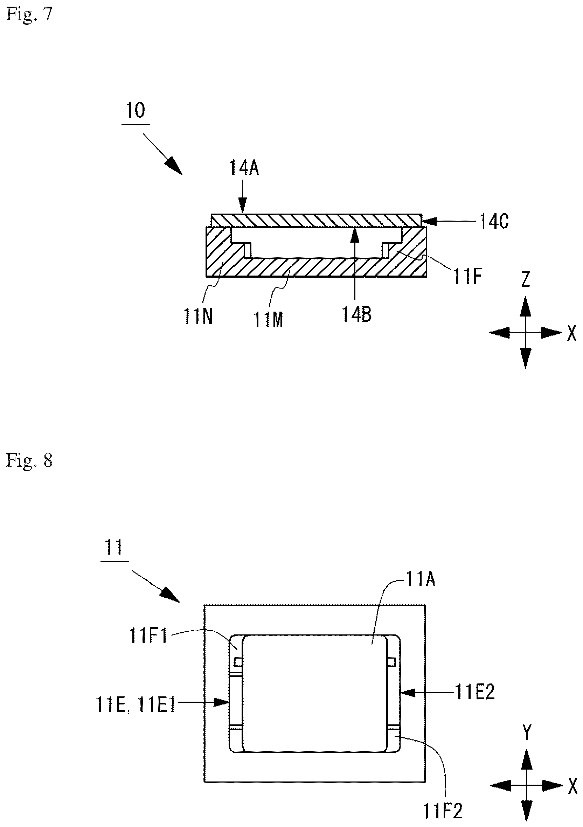

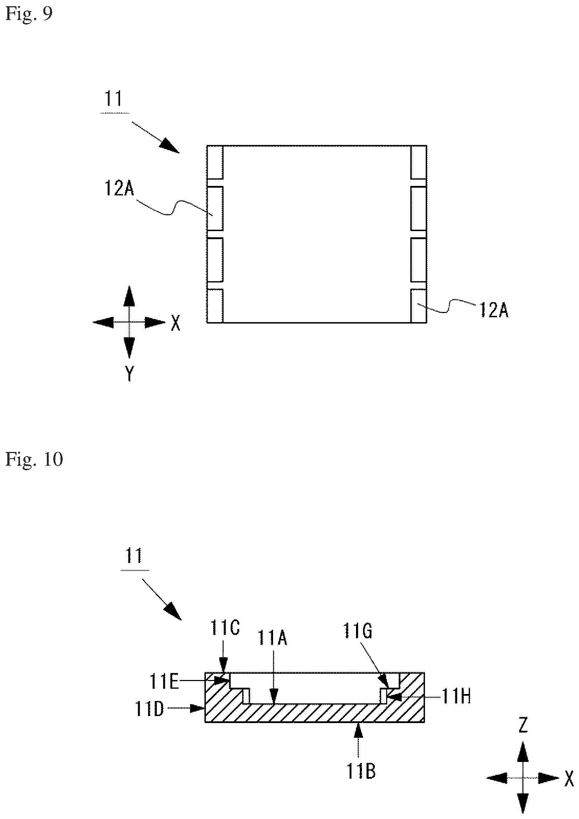

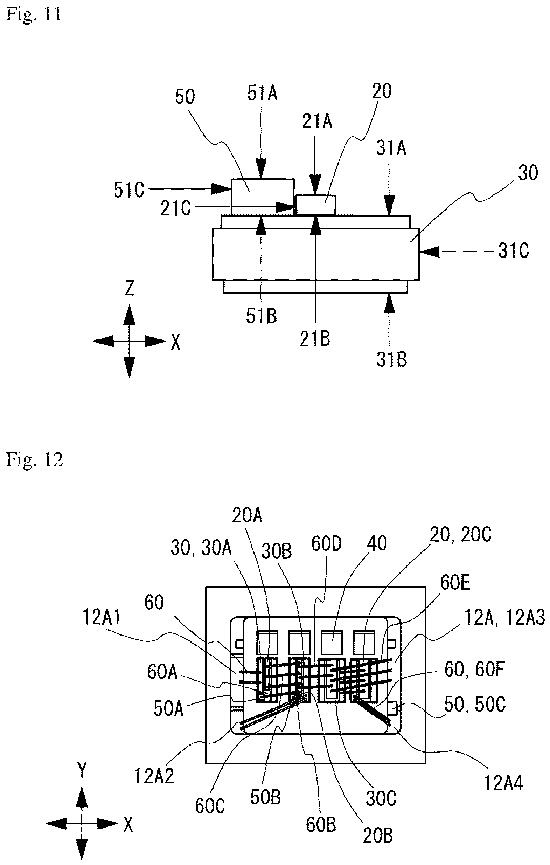

FIGS. 6B and 6C are schematic supplementary diagrams in which some components or reference numerals are removed from FIG. 6A, and certain reference numerals are indicated more clearly. FIG. 7 is a schematic sectional view of a package 10 of the light-emitting device 1. Note that, the schematic sectional view of FIG. 7 corresponds to the cross section taken along line IV-IV of FIG. 3. FIG. 8 is a schematic top view of a base 11 of the light-emitting device 1. FIG. 9 is a schematic bottom view of the base 11. FIG. 10 is a schematic sectional view of the base 11. Note that, the schematic sectional view of FIG. 10 corresponds to the cross section taken along line IV-IV of FIG. 3. FIG. 11 is a schematic view of a semiconductor laser element 20 and a protective element 50 disposed on a submount 30.

The light-emitting device 1 includes a plurality of components. The plurality of components include the package 10, one or more semiconductor laser elements 20, one or more submounts 30, one or more reflective members 40, one or more protective elements 50, a plurality of wires 60, and an optical member 70.

The light-emitting device 1 may include a component other than the components described above. For example, the light-emitting device 1 may further include a semiconductor laser element different from the one or more semiconductor laser elements 20. The light-emitting device 1 need not include some of the components described above.

Firstly, each of the components will be described.

### Package 10

The package 10 includes the base 11 and a lid body 14. The lid body 14 is joined to the base 11 to form the package 10. An internal space in which other components are disposed is defined in the package 10. The internal space is a closed space surrounded by the base 11 and the lid body 14. The internal space can also be a sealed space in a vacuum or airtight state.

The outer edge shape of the package 10 in a top view is rectangular. This rectangular shape can be a rectangular shape with long sides and short sides. In the illustrated package 10, the long-side direction of the rectangular shape is the same direction as the X direction, and the short-side direction of the rectangular shape is the same direction as the Y direction. The outer edge shape of the package 10 in a top view need not be rectangular.

The internal space in which other components are disposed is formed in the package 10. A first upper surface 11A of the package 10 is a part of a region defining the internal space. In addition, inner lateral surfaces 11E and the lower surface 14B of the package 10 are a part of the region defining the internal space.

The base 11 has the first upper surface 11A and a lower surface 11B. The base 11 has a second upper surface 11C. The base 11 has one or more outer lateral surfaces 11D. The base 11 has one or more inner lateral surfaces 11E. The one or more outer lateral surfaces 11D meet the second upper surface 11C. The one or more outer lateral surfaces 11D meet the lower surface 11B. The one or more inner lateral surfaces 11E meet the second upper surface 11C.

The outer edge shape of the base 11 in a top view is rectangular. The outer edge shape of the base 11 in a top view is the outer edge shape of the package 10. The outer edge shape of the first upper surface 11A in a top view is rectangular. This rectangular shape can be a rectangular shape with long sides and short sides. The long-side direction of the first upper surface 11A is parallel to the long-side direction of the outer edge shape of the base 11. The outer edge shape of the first upper surface 11A in a top view need not be rectangular.

In a top view, the first upper surface 11A is surrounded by the second upper surface 11C. The second upper surface 11C is an annular surface surrounding the first upper surface 11A in a top view. The second upper surface 11C is a rectangular annular surface. Here, a frame defined by an inner edge of the second upper surface 11C is referred to as an inner frame of the second upper surface 11C, and a frame defined by an outer edge of the second upper surface 11C is referred to as an outer frame of the second upper surface 11C.

The base 11 has a recessed portion surrounded by the frame formed by the second upper surface 11C. The recessed portion defines a portion recessed downward from the second upper surface 11C in the base 11. The first upper surface 11A is a part of the recessed portion. The one or more inner lateral surfaces 11E are a part of the recessed portion. The second upper surface 11C is located above the first upper surface 11A.

The base 11 includes one or more step portions 11F. Each of the step portions 11F includes an upper surface 11G and a lateral surface 11H that meets the upper surface 11G and extends downward from the upper surface 11G. Here, one step portion 11F has only one upper surface 11G and only one lateral surface 11H. The upper surface 11G meets the inner lateral surface 11E. The lateral surface 11H meets the first upper surface 11A.

One or each of the step portions 11F is formed on an inner side of the inner frame of the second upper surface 11C in a top view. One or each of the step portions 11F is formed along a part of or the entire inner lateral surface 11E in a top view. In the base 11, the lateral surface 11H is an inner lateral surface, but the lateral surface 11H and the inner lateral surface 11E are different surfaces. One or each of the inner lateral surfaces 11E and one or each of the lateral surfaces 11H are perpendicular to the first upper surface 11A. The term "perpendicular" as used here allows for a difference within ± 3 degrees.

The one or more step portions 11F can include a first step portion 11F1 and a second step portion 11F2. The first step portion 11F1 and the second step portion 11F2 are provided at positions where the respective lateral surfaces 11H are opposed to each other. The first step portion 11F1 and the second step portion 11F2 are provided on sides of the short sides of the inner frame of the second upper surface 11C.

The base 11 includes a base portion 11M and a frame portion 11N. The base portion 11M and the frame portion 11N may be members made of mutually different materials. The base 11 can include a base member corresponding to the base portion 11M and a frame member corresponding to the frame portion 11N.

The base portion 11M has the first upper surface 11A. The frame portion 11N has the second upper surface 11C. The frame portion 11N has the one or more outer lateral surfaces 11D and the one or more inner lateral surfaces 11E. The frame portion 11N includes the one or more step portions 11F.

The lower surface of the base portion 11M constitutes a part or the entire region of the lower surface 11B of the base 11. When the lower surface of the base portion 11M constitutes a part of the region of the lower surface 11B of the base 11, the lower surface of the frame portion 11N constitutes the remaining region of the lower surface 11B of the base 11.

The base 11 includes a plurality of wiring parts 12A. The plurality of wiring parts 12A include one or more wiring parts 12A disposed in the internal space of the package 10, and one or more wiring parts 12A provided on the outer surface of the package 10.

One or each of the wiring parts 12A disposed in the internal space of the package 10 is provided on the upper surface 11G of the step portion 11F. The base 11 includes the one or more wiring parts 12A provided on the upper surface 11G of the first step portion 11F1 provided on the upper surface 11G of the first step portion 11F1. The base 11 includes the one or more wiring parts 12A provided on the upper surface 11G of the second step portion 11F2.

One or each of the wiring parts 12A provided on the outer surface of the package 10 is provided on the lower surface 11B of the package 10. Each wiring part 12A is provided on the lower surface of the frame portion 11N. Note that, some or all of the wiring parts 12A may be provided on the outer surface that is different from the lower surface 11B of the package 10.

At the base 11, one or each of the wiring parts 12A disposed in the internal space of the package 10 is electrically connected to the wiring part 12A provided on the outer surface of the package 10.

The base 11 can be formed using a ceramic as a main material, for example. Examples of the ceramic as the main material of the base 11 include aluminum nitride, silicon nitride, aluminum oxide, and silicon carbide.

Here, a main material refers to a material that accounts for the greatest proportion of a target formed product in terms of mass or volume. When a target formed product is formed of a single material, the material is the main material. In other words, when a certain material is the main material, the proportion of the material may be 100%.

The base 11 may be formed using a base member and a frame member formed of main materials different from each other. The base member can be formed using a main material having excellent heat dissipation, for example, a metal or a composite containing a metal, graphite, or diamond. Examples of the metal as the main material of the base member include, for example, copper, aluminum, and iron. Examples of the composite containing the metal as the main material of the base member include, for example, copper-molybdenum and copper-tungsten. The frame member can be formed using, as a main material, for example, any of the ceramics exemplified above as the main material of the base 11.

The wiring part 12A can be formed using a metal material as a main material, for example. Examples of the metal material as the main material of the wiring part 12A include single-component metals, such as Cu, Ag, Ni, Au, Ti, Pt, Pd, Cr, and W, and alloys containing any of these metals. The wiring part 12A can be constituted by one or more metal layers, for example.

The lid body 14 has an upper surface 14A and a lower surface 14B. The lid body 14 also has one or more lateral surfaces 14C. The lid body 14 is formed of a flat plate with a rectangular parallelepiped shape. The lid body 14 does not necessarily have a rectangular parallelepiped shape.

The lid body 14 is joined to the base 11. The lower surface 14B of the lid body 14 is joined to the second upper surface 11C of the base 11. The lid body 14 is joined to the joining pattern of the base 11. The lid body 14 is joined to the base 11 via an adhesive.

The lid body 14 has transmissivity to transmit light. The term "transmissivity" as used here refers to the transmittance for light incident on the lid body 14 being equal to or more than 80%. The lid body 14 may partially include a non-light transmitting region (a region with no transmissivity).

The lid body 14 can be formed using glass as a main material, for example. The lid body 14 can also be formed using sapphire as a main material, for example.

### Semiconductor Laser Element 20

The semiconductor laser element 20 has an upper surface 21A, a lower surface 21B, and a plurality of lateral surfaces 21C. A shape of the upper surface 21A is a rectangle having long sides and short sides. An outer shape of the semiconductor laser element 20 in a top view is a rectangle having long sides and short sides. The shape of the upper surface 21A and the outer shape of the semiconductor laser element 20 in the top view are not limited thereto.

The semiconductor laser element 20 has a light-emitting surface 22 from which light is emitted. For example, the lateral surface 21C may serve as the light-emitting surface 22. The lateral surface 21C serving as the light-emitting surface 22 meets a short side of the upper surface 21A. For example, the upper surface 21A can serve as the light-emitting surface 22.

As the semiconductor laser element 20, a single-emitter semiconductor laser element including one emitter can be employed. As the semiconductor laser element 20, a multi-emitter semiconductor laser element including a plurality of emitters can be employed.

As the semiconductor laser element 20, for example, a semiconductor laser element that emits blue light can be employed. Also, for example, as the semiconductor laser element 20, a semiconductor laser element that emits green light can be employed. Also, for example, as the semiconductor laser element 20, a semiconductor laser element that emits red light can be employed. A semiconductor laser element that emits light of another color or light having another wavelength may be employed as the semiconductor laser element 20.

Here, blue light refers to light having a light emission peak wavelength within a range from 420 nm to 494 nm. Green light refers to light having a light emission peak wavelength within a range from 495 nm to 570 nm. Red light refers to light having a light emission peak wavelength within a range from 605 nm to 750 nm.

Examples of the semiconductor laser element 20 that emits blue light or the semiconductor laser element 20 that emits green light include a semiconductor laser element including a nitride semiconductor. A GaN-based semiconductor, such as GaN, InGaN, or AlGaN, can be employed as the nitride semiconductor. Examples of the semiconductor laser element 20 that emits red light include a semiconductor laser element including an InAlGaP-based semiconductor, a GaInP-based semiconductor, or a GaAs-based semiconductor, such as GaAs or AlGaAs.

The semiconductor laser element 20 emits a directional laser beam. Divergent light that spreads is emitted from the light-emitting surface 22 (emission end surface) of the semiconductor laser element 20. The light emitted from the semiconductor laser element 20 forms a far-field pattern (hereinafter referred to as an "FFP") with an elliptical shape in a plane parallel to the light-emitting surface 22. The FFP indicates a shape or a light intensity distribution of the emitted light at a position spaced apart from the light-emitting surface of the semiconductor laser element.

Here, light passing through the center of the elliptical shape of the FFP, in other words, light having a peak intensity in the light intensity distribution of the FFP is referred to as light traveling along an optical axis or light passing through an optical axis. Based on the light intensity distribution of the FFP, light having an intensity that is equal to or more than 1/e² with respect to the peak intensity is referred to as a main portion of the light.

The shape of the FFP of the light emitted from the semiconductor laser element 20 has an elliptical shape in which a length in a layering direction is longer than that in a direction perpendicular to the layering direction in the plane parallel to the light-emitting surface 22. The layering direction is a direction in which a plurality of semiconductor layers including an active layer are layered in the semiconductor laser element 20. The direction perpendicular to the layering direction can also be referred to as a plane direction of the semiconductor layer. A long diameter direction of the elliptical shape of the FFP can also be referred to as a fast axis direction of the semiconductor laser element 20, and a short diameter direction of the elliptical shape of the FFP can also be referred to as a slow axis direction of the semiconductor laser element 20.

Based on the light intensity distribution of the FFP, an angle at which light having a light intensity of 1/e² of a peak light intensity spreads is referred to as a divergence angle of light of the semiconductor laser element 20. Here, the divergence angle of light is indicated as an angle formed by light having the peak light intensity (light passing through an optical axis) and light having a light intensity of 1/e² of the peak light intensity. In some cases, the divergence angle of light can also be determined based on, for example, the light intensity that is half of the peak light intensity, other than being determined based on the light intensity of 1/e² of the peak light intensity. In the present specification, the term "divergence angle of light" by itself refers to a divergence angle of light at the light intensity of 1/e² of the peak light intensity.

### Submount 30

The submount 30 has an upper surface 31A, a lower surface 31B, and one or more lateral surfaces 31C. It can be said that the upper surface 31A is a mounting surface on which other components are mounted. The shape of the upper surface 31A is rectangular. The rectangular shape of the upper surface 31A can have short sides and long sides. The shape of the upper surface 31A need not be rectangular.

The outer shape of the submount 30 in a top view is rectangular. The rectangular shape of the submount 30 can have short sides and long sides. The outer shape of the submount 30 in a top view need not be rectangular. The submount 30 can have an outer shape having a length in one direction (hereinafter, the direction is referred to as a lateral direction of the submount 30) smaller than a length in a direction (hereinafter, the direction is referred to as a longitudinal direction of the submount 30) perpendicular to the one direction in a top view. In the submount 30 illustrated by the drawings, the lateral direction is the same direction as the X direction, and the longitudinal direction is the same direction as the Y direction.

For example, a length of the submount 30 in the short-side direction or the lateral direction is in a range from 500 µm to 1000 µm. A length of the submount 30 in the long-side direction or the longitudinal direction is in a range from 1500 µm to 2500 µm. A difference between the length in the longitudinal direction and the length in the lateral direction of the submount 30 is in a range from 500 µm to 1000 µm.

### Reflective Member 40

The reflective member 40 has a lower surface 41A, and a light-reflective surface 41B that reflects light. The light-reflective surface 41B is inclined with respect to the lower surface 41A. A straight line connecting a lower end and an upper end of the light-reflective surface 41B is inclined with respect to the lower surface 41A. An angle at which the light-reflective surface 41B is inclined with respect to the lower surface 41A is referred to as an inclination angle of the light-reflective surface 41B.

The light-reflective surface 41B is a flat surface. The light-reflective surface 41B may be a curved surface. The inclination angle of the light-reflective surface 41B is 45 degrees. The light-reflective surface 41B need not have an inclination angle of 45 degrees.

As the main material of the reflective member 40, glass or metal can be used. A heat-resistant material is preferably used as the main material of the reflective member 40. As the main material, for example, a glass such as quartz glass or borosilicate glass (BK7), or a metal such as Al can be used. The reflective member 40 can also be formed using Si as the main material.

When the main material is a reflective material such as Al, the light-reflective surface 41B can be formed of the main material. Instead of forming the light-reflective surface 41B with the main material, a general form of the reflective member 40 may be formed with the main material, and the light-reflective surface 41B may be formed on a surface of the general form. In this case, the light-reflective surface 41B can be formed using, for example, a layer of a metal such as Ag or Al, or a dielectric multilayer film of Ta₂O₅/SiO₂, TiO₂/SiO₂, or Nb₂O₅/SiO₂.

In the light-reflective surface 41B, the reflectance with respect to the peak wavelength of the light with which the light-reflective surface 41B is irradiated is equal to or more than 90%. The reflectance may be equal to or more than 95%. The reflectance may be equal to or more than 99%. The light reflectance is equal to or less than 100% or is less than 100%.

### Protective Element 50

The protective element 50 has an upper surface 51A, a lower surface 51B, and one or more lateral surfaces 51C. The shape of the protective element 50 is a rectangular parallelepiped. The shape of the protective element 50 need not be a rectangular parallelepiped.

The protective element 50 prevents breakage of a specific element (the semiconductor laser element, for example) due to an excessive current flowing through the element. The protective element 50 is, for example, a Zener diode. A Zener diode formed of Si can be used.

### Wire 60

The wire 60 is a linear conductive material having joining portions at both ends. The joining portions at both ends serve as portions for joining with other components. The wire 60 is used for electrical connection between two components. The wire 60 is, for example, a metal wire. The metal used can be, for example, gold, aluminum, silver, or copper.

### Optical Member 70

The optical member 70 has an upper surface 71A, a lower surface 71B, and one or more lateral surfaces 71C. The optical member 70 imparts an optical action to light that is incident on the optical member 70. Examples of the optical action imparted to the light by the optical member 70 include condensing, collimation, diffusion, polarization, diffraction, multiplexing, light guiding, reflection, and wavelength conversion.

The optical member 70 has an optical action surface that imparts the optical action. The upper surface 71A, the lower surface 71B, or the lateral surface 71C can serve as the optical action surface. Alternatively, the optical action surface may be provided at a position different from the upper surface 71A, the lower surface 71B, or the lateral surface 71C. For example, the optical action surface may be formed not on a surface of the optical member 70 but on an inner side of the optical member 70.

The optical member 70 can have one or more lens surfaces 71D. The lens surface 71D is the optical action surface of the optical member 70. The optical member 70 having the lens surface 71D may be referred to as a lens member. Light passing through the lens surface 71D and emitted from the optical member 70 is imparted an optical action of condensing, diffusion, or collimation by the optical member 70. For example, the optical member 70 is a collimating lens that collimates light that is incident on the optical member 70 and emits the collimated light.

One or each of the lens surfaces 71D is provided on the upper surface 71A side. Note that the lens surface 71D may be provided on the lower surface 71B side. The upper surface 71A and the lower surface 71B are flat surfaces. The one or each of the lens surfaces 71D meets the upper surface 71A. In a top view, the one or each of the lens surfaces 71D is surrounded by the upper surface 71A.

The outer shape of the optical member 70 in a top view is rectangular. The outer shape of the optical member 70 in a top view need not be rectangular. The lower surface 71B is a flat surface. The lens surface 71D is not formed on the lower surface 71B side of the optical member 70. The shape of the lower surface 71B is rectangular. The shape of the lower surface 71B need not be rectangular.

In the optical member 70, a portion overlapping with the lens surface 71D in a top view is a lens portion 72A. In the optical member 70, a portion overlapping with the upper surface 71A in a top view is a non-lens portion 72B. The lower surface 71B has a region constituting the lower surface of one or each of the lens portions 72A and a region constituting the lower surface of the non-lens portion 72B.

The optical member 70 can have a plurality of the lens surfaces 71D formed continuously in one direction. A direction in which the plurality of lens surfaces 71D are aligned in a top view is referred to as a coupling direction of the lenses. In the illustrated optical member 70, the coupling direction is the same direction as the X direction.

The plurality of lens surfaces 71D are formed such that the vertices of the respective lens surfaces 71D are provided on one straight line. The virtual straight line connecting the respective vertices is parallel to the lower surface 71B of the optical member 70. The term "parallel" as used here allows for a difference within ± 5 degrees.

The curvatures of two or more lens surfaces 71D, that is, some or all of the plurality of lens surfaces 71D can be the same. The plurality of lens surfaces 71D can all have the same curvatures.

The optical member 70 has transmissivity. In the optical member 70, the transmittance with respect to the peak wavelength of light incident on the optical member 70 is equal to or more than 80%. The optical member 70 may include a region having transmissivity and a region having no transmissivity (hereinafter, referred to as a non-light transmitting region). In the non-light transmitting region, the transmittance with respect to the peak wavelength of light incident on the optical member 70 is equal to or less than 50%. The optical member 70 can be formed using, for example, glass such as BK7.

Subsequently, a light-emitting device will be described.

### Light-Emitting Device 1

In the light-emitting device 1, the one or more semiconductor laser elements 20 are disposed in the internal space of the package 10. The one or more semiconductor laser elements 20 are disposed on the first upper surface 11A. The one or more semiconductor laser elements 20 are disposed on the first upper surface 11A with the one or more submounts 30 therebetween.

The one or more semiconductor laser elements 20 may be composed of a plurality of the semiconductor laser elements 20 including a first semiconductor laser element 20A and a second semiconductor laser element 20B. The plurality of semiconductor laser elements 20 may further include the one or more third semiconductor laser elements 20C.

The second semiconductor laser element 20B is longer than the first semiconductor laser element 20A in the resonator direction. The resonator direction is the direction perpendicular to the light-emitting surface 22. In the example of the light-emitting device 1 illustrated in the drawing, the resonator direction is the same direction as the Y direction.

The length of the first semiconductor laser element 20A in the resonator direction may be in a range from 500 µm to 1500 µm. The length of the second semiconductor laser element 20B in the resonator direction is greater than the length of the first semiconductor laser element 20A in the resonator direction by a range from 200 µm to 1500 µm.

The plurality of semiconductor laser elements 20 may be arranged in one direction. The plurality of semiconductor laser elements 20 may be arranged in the long-side direction of the package 10. The resonator direction of each semiconductor laser element 20 may be the same direction as the short-side direction of the package 10. In this manner, a larger number of semiconductor laser elements 20 can be arranged in the package 10.

The one or more inner lateral surfaces 11E include a first inner lateral surface 11E1 and a second inner lateral surface 11E2 that face each other. In top view, the plurality of semiconductor laser elements 20 are arranged in one direction between the first inner lateral surface 11E1 and the second inner lateral surface 11E2. A direction in which the first inner lateral surface 11E1 and the second inner lateral surface 11E2 face each other is the same as the direction in which the plurality of semiconductor laser elements 20 are arranged.

The first semiconductor laser element 20A is located closer to the first inner lateral surface 11E1 than the second semiconductor laser element 20B is to the first inner lateral surface 11E1. The distance from the first semiconductor laser element 20A to the first inner lateral surface 11E1 is shorter than the distance from the second semiconductor laser element 20B to the first inner lateral surface 11E1.

The second semiconductor laser element 20B is disposed closer to the first inner lateral surface 11E1 than the third semiconductor laser element 20C is to the first inner lateral surface 11E1. The second semiconductor laser element 20B is disposed at a position separated from the first semiconductor laser element 20A in a predetermined direction, and the one or more third semiconductor laser elements 20C are disposed at a position separated from the second semiconductor laser element 20B in the same direction.

The one or more semiconductor laser elements 20 emit light laterally from the light-emitting surface 22. The plurality of semiconductor laser elements 20 emit light in the same direction. The plurality of semiconductor laser elements 20 are disposed such that the respective light-emitting surfaces 22 face the same direction. In the example of the light-emitting device 1 illustrated in the drawing, each semiconductor laser element 20 emits light in the positive Y direction.

The light emission peak wavelength of the light emitted from the first semiconductor laser element 20A and the light emission peak wavelength of the light emitted from the second semiconductor laser element 20B differ by 50 nm or more. The color of the light emitted from the first semiconductor laser element 20A is different from the color of the light emitted from the second semiconductor laser element 20B.

The first semiconductor laser element 20A, the second semiconductor laser element 20B, and the third semiconductor laser element 20C emit light in different colors and emit light of one of red, green, or blue. The three semiconductor laser elements 20 emit red, green, and blue light.

The first semiconductor laser element 20A has a higher wall plug efficiency (WPE) than the second semiconductor laser element 20B. For example, the first semiconductor laser element 20A emits blue light, and the second semiconductor laser element 20B emits green light.

In top view, in the direction perpendicular to the resonator direction, the width of the first semiconductor laser element 20A and the width of the second semiconductor laser element 20B are the same. Here, "the same" includes a difference within 30 µm.

In the light-emitting device 1, the one or more submounts 30 are disposed in the internal space of the package 10. The one or more submounts 30 are disposed on the first upper surface 11A. The one or more semiconductor laser elements 20 are disposed on the upper surface 31A of one or each of the submounts 30.

The one or more submounts 30 may be composed of a plurality of submounts 30 including a first submount 30A and a second submount 30B. The plurality of submounts 30 may further include one or more third submounts 30C.

The first semiconductor laser element 20A is disposed on the first submount 30A. The second semiconductor laser element 20B is disposed on the second submount 30B. The third semiconductor laser element 20C is disposed on the third submount 30C.

In top view, the length of the first submount 30A in the longitudinal direction and the length of the second submount 30B in the longitudinal direction are the same. Here, "the same" includes a difference within 100 µm. In addition, in top view, the length of the first submount 30A in the lateral direction and the length of the second submount 30B in the lateral direction are the same. Here, "the same" includes a difference within 100 µm.

The first semiconductor laser element 20A is disposed on the first submount 30A with the long side of the upper surface 21A of the first semiconductor laser element 20A aligned with the longitudinal direction of the first submount 30A. The resonator direction of the first semiconductor laser element 20A may be the same direction as the longitudinal direction of the first submount 30A. Here, "the same" includes a difference within ± 3 degrees.

The second semiconductor laser element 20B is disposed on the second submount 30B with the long side of the upper surface 21A of the second semiconductor laser element 20B aligned with the longitudinal direction of the second submount 30B. The resonator direction of the second semiconductor laser element 20B may be the same direction as the longitudinal direction of the first submount 30A. Here, "the same" includes a difference within ± 3 degrees.

In the light-emitting device 1, two semiconductor laser elements 20 that have different lengths in the resonator direction are disposed on two submounts 30 that have the same length in the longitudinal direction.

In the light-emitting device 1, the one or more reflective members 40 are disposed in the internal space of the package 10. One or more reflective members 40 are disposed on the first upper surface 11A. One or more reflective members 40 reflect light emitted from the one or more semiconductor laser elements 20.

The light-reflective surface 41B of one or each of the reflective members 40 faces the direction of the light-emitting surface 22 of the semiconductor laser element 20. Light emitted from the semiconductor laser element 20 along the optical axis is reflected by the light-reflective surface 41B and travels vertically upward with respect to the optical axis.

In the light-emitting device 1, the one or more protective elements 50 are disposed in the internal space of the package 10. The one or more protective elements 50 protect the one or more semiconductor laser elements 20.

The one or more protective elements 50 may be composed of a plurality of the protective elements 50 including a first protective element 50A and a second protective element 50B. The plurality of protective elements 50 may further include a third protective element 50C.

The first protective element 50A protects the first semiconductor laser element 20A. The second protective element 50B protects the second semiconductor laser element 20B. The third protective element 50C protects the one or more third semiconductor laser elements 20C.

The first protective element 50A is disposed on the first submount 30A. The second protective element 50B is disposed on the second submount 30B. The third protective element 50C is not disposed on the submount 30. The third protective element 50C is disposed on the wiring part 12A.

The first protective element 50A is disposed closer to the first inner lateral surface 11E1 than the first semiconductor laser element 20A. The second protective element 50B is disposed closer to the first inner lateral surface 11E1 than the second semiconductor laser element 20B.

Here, in the semiconductor laser element 20, the surface located on the side opposite to the light-emitting surface 22 is referred to as a first surface 23. In a case in which a certain lateral surface 31C in the semiconductor laser element 20 is the light-emitting surface 22, the lateral surface 31C located on the side opposite to the light-emitting surface 22 is the first surface 23. In addition, the direction in which light travels toward the light-emitting surface 22 from the first surface 23 of the semiconductor laser element 20 is referred to as a first direction.

The first protective element 50A is disposed close to the first surface 23 of the first semiconductor laser element 20A. In a top view, the distance from the first protective element 50A to the first surface 23 of the first semiconductor laser element 20A is shorter than the distance from the first protective element 50A to the light-emitting surface 22 of the first semiconductor laser element 20A. The first surface 23 of the first semiconductor laser element 20A is disposed at a position separated from the first protective element 50A in the first direction.

The second protective element 50B is disposed close to the first surface 23 of the second semiconductor laser element 20B. In a top view, the distance from the second protective element 50B to the first surface 23 of the second semiconductor laser element 20B is shorter than the distance from the second protective element 50B to the light-emitting surface 22 of the second semiconductor laser element 20B.

In a top view, the distance from the light-emitting surface 22 of the first semiconductor laser element 20A to the first protective element 50A and the distance from the light-emitting surface 22 of the second semiconductor laser element 20B to the second protective element 50B are the same. Here, "the same" includes a difference within 100 µm.

The relative position where the first protective element 50A is disposed on the upper surface 31A of the first submount 30A and the relative position where the second protective element 50B is disposed on the upper surface 31A of the second submount 30B are the same.

The first protective element 50A and the second protective element 50B are the protective elements 50 having the same size. The third protective element 50C is the protective element 50 having a larger size than the first protective element 50A. The third protective element 50C is the protective element 50 having a larger size than the second protective element 50B. In top view, the size of the upper surface 51A of the third protective element 50C has a size with which the third protective element 50C cannot be disposed without making contact with the third semiconductor laser element 20C and without protruding from the upper surface 31A of the third submount 30C.

In the light-emitting device 1, the plurality of wires 60 are electrically connected to the one or more semiconductor laser elements 20. In addition, the plurality of wires 60 are electrically connected to the one or more protective elements 50.

The light-emitting device 1 electrically connects the one or more semiconductor laser elements 20 to the package 10 through the plurality of wires 60. Further, through the plurality of wires 60, the one or more protective elements 50 are electrically connected to the package 10.

The plurality of wires 60 include a first wire 60A that is joined to the first protective element 50A. The first wire 60A is not joined to the first semiconductor laser element 20A. The first wire 60A is not joined to the first submount 30A. The first wire 60A is joined to the wiring part 12A.

The plurality of wires 60 include a second wire 60B that is joined to the second protective element 50B. The second wire 60B is joined to the upper surface 21A of the second semiconductor laser element 20B.

By utilizing the fact that the second semiconductor laser element 20B is longer than the first semiconductor laser element 20A in the resonator direction, the other end of the second wire 60B whose one end is joined to the second protective element 50B is joined to the upper surface 21A of the second semiconductor laser element 20B, and thus the length of the second wire 60B can be suppressed, thereby suppressing the wiring resistance.

The second semiconductor laser element 20B is not necessarily longer than the first semiconductor laser element 20A in the resonator direction. As can be understood from FIG. 6A, etc., even when a length of the first semiconductor laser element 20A in the resonator direction is the same as a length of the second semiconductor laser element 20B in the resonator direction, the upper surface 21A of the second semiconductor laser element 20B can be utilized for bonding of the second wire 60B.

As illustrated in FIGS. 6A to 6C, in top view, the second wire 60B is disposed such that it does not pass through a virtual straight line L1. Here, in top view, the virtual straight line L1 is a parallel straight line that passes through the first surface 23 of the first semiconductor laser element 20A.

The plurality of wires 60 include a third wire 60C that is joined to the upper surface 21A of the first semiconductor laser element 20A.

The plurality of wires 60 may include a plurality of the third wires 60C. Each of the plurality of third wires 60C is not joined to the protective element 50. By disposing the first semiconductor laser element 20A at a position separated from the first protective element 50A in the first direction, the first wire 60A and the third wire 60C can be easily joined.

The plurality of wires 60 include a fourth wire 60D joined to the upper surface 21A of the second semiconductor laser element 20B. The plurality of wires 60 include a plurality of the fourth wires 60D. Each of the plurality of fourth wires 60D is not joined to the protective element 50. Note that, the plurality of fourth wires 60D are the wires 60 that do not include the second wire 60B.

In top view, when the upper surface 21A of the second semiconductor laser element 20B is divided into two regions by the virtual straight line L1, one or more fourth wires 60D are joined to one region, and the second wire 60B is joined to the other region. The fourth wire 60D is joined to the upper surface 21A of the second semiconductor laser element 20B at a position separated from the second wire 60B in the first direction.

In this manner, the light-emitting device 1 includes the first semiconductor laser element 20A where the wires other than the plurality of third wires 60C are not joined to the upper surface 21A, and the second semiconductor laser element 20B where the second wire 60B is also joined to the upper surface 21A in addition to the plurality of fourth wires 60D in accordance with the difference in the length of the upper surface 21A in the resonator direction. Note that, the wires other than the second wire 60B and the plurality of fourth wires 60D are not joined to the upper surface 21A of the second semiconductor laser element 20B.

The wire 60 joined to the first protective element 50A is only the first wire 60A. The wire 60 joined to the second protective element 50B is only the second wire 60B. The first wire 60A is longer than the second wire 60B. The number of the plurality of third wires 60C and the number of the plurality of fourth wires 60D are the same. The third wire 60C is shorter than the fourth wire 60D. By matching the number of the third wires 60C and the number of the fourth wires 60D, the difference in electrical load applied to each wire 60 can be reduced, thus contributing to a stable wire connection.

The plurality of fourth wires 60D are joined to the second semiconductor laser element 20B at a position closer to the light-emitting surface 22 than the second wire 60B. As illustrated in FIGS. 6A to 6C, the distance from a position P1, where the fourth wire 60D is joined to the upper surface 21A of the second semiconductor laser element 20B, to the light-emitting surface 22 of the second semiconductor laser element 20B is shorter than the distance from a position P2, where the second wire 60B is joined to the upper surface 21A of the second semiconductor laser element 20B, to the light-emitting surface 22 of the second semiconductor laser element 20B. Note that, this relationship holds not only for the fourth wire 60D indicated by the arrow P1 in FIG. 6A, but also for the fourth wire 60D that is farthest from the light-emitting surface 22.

Regarding the resonator direction, the distance from the light-emitting surface 22 of the first semiconductor laser element 20A to the third wire 60C that is closest to that light-emitting surface 22 is shorter than the distance from the light-emitting surface 22 of the second semiconductor laser element 20B to the fourth wire 60D that is closest to that light-emitting surface 22. In this manner, the plurality of wires 60 can be joined with a good balance in accordance with the length in the resonator direction, and the quality of the semiconductor laser element 20 can be improved.

The package 10 includes the plurality of wiring parts 12A, each of which is joined to one or more wires 60 of the plurality of wires 60. The plurality of wiring parts 12A include a first wiring part 12A1 and a second wiring part 12A2. In addition, the plurality of wiring parts 12A include a third wiring part 12A3 and a fourth wiring part 12A4.

The first wire 60A is joined to the first wiring part 12A1. The third wire 60C is joined to the first wiring part 12A1. The plurality of third wires 60C are joined to the first wiring part 12A1. The fourth wire 60D is joined to the second wiring part 12A2. The plurality of fourth wires 60D are joined to the second wiring part 12A2.

The plurality of wires 60 include one or more fifth wires 60E joined to the third wiring part 12A3, and one or more sixth wires 60F joined to the fourth wiring part 12A4. The one or more fifth wires 60E are joined to the third semiconductor laser element 20C. The one or more sixth wires 60F are joined to the third submount 30C.

The first wiring part 12A1 and the second wiring part 12A2 are provided on the first inner lateral surface 11E1 side. Accordingly, the distance from the first semiconductor laser element 20A to the first wiring part 12A1 is shorter than the distance from the second semiconductor laser element 20B to the first wiring part 12A1.

The first wiring part 12A1 and the second wiring part 12A2 are arranged in the resonator direction. The first wiring part 12A1 is provided at a position separated from the second wiring part 12A2 in the first direction. The first wiring part 12A1 and the second wiring part 12A2 are provided on the upper surface 11G of the first step portion 11F1. Regarding the resonator direction, the sum of the lengths of the first wiring part 12A1 and the second wiring part 12A2 is greater than the length of the first submount 30A.

The third wiring part 12A3 and the fourth wiring part 12A4 are provided on the second inner lateral surface 11E2 side. The third wiring part 12A3 and the fourth wiring part 12A4 are arranged in the resonator direction. The third wiring part 12A3 is provided at a position separated from the fourth wiring part 12A4 in the first direction. The third wiring part 12A3 and the fourth wiring part 12A4 are provided on the upper surface 11G of the second step portion 11F2.

When the position where the fourth wire 60D is joined to the second wiring part 12A2 in the light-emitting device 1 is set as a position P3, the position P1 is located further in the first direction relative to the first protective element 50A, and the position P3 is located further in a direction opposite to the first direction relative to the first protective element 50A as illustrated in FIGS. 6A to 6C. With the second wire 60B is joined to the second semiconductor laser element 20B, the second wire 60B and the fourth wire 60D do not overlap in top view even when the fourth wire 60D is provided as described above, and thus contact between wires can be easily avoided.

When the position where the first wire 60A is joined to the first wiring part 12A1 in the light-emitting device 1 is set as a position P4, the position P4 is located further in the first direction relative to the position P3. In addition, the position P4 is located further in the direction opposite to the first direction relative to the position P1. When the position where the third wire 60C is joined to the first wiring part 12A1 in the light-emitting device 1 is set as a position P5, the position P5 is located further in the first direction relative to the position P4.

In top view, the third wire 60C and the fourth wire 60D do not overlap. The plurality of fourth wires 60D include the one or more fourth wires 60D that extends over the first submount 30A in a top view. The term "pass through" does not include the case in which one end of the fourth wire 60D overlaps the first submount 30A in top view. That is, both ends of the fourth wire 60D are located outside the first submount 30A in top view.

In top view, the one or more fourth wires 60D are joined to the upper surface 21A of the second semiconductor laser element 20B and the second wiring part 12A2 such that a virtual straight line L2 that passes through the second protective element 50B and extends in the second direction perpendicular to the first direction passes through the one or more fourth wires 60D.

In top view, the plurality of fourth wires 60D pass between the position where the first wire 60A is joined to the first protective element 50A and the position where the second wire 60B joined to the second protective element 50B. The position P3 is located further in the first direction relative to the first submount 30A. The position P3 is located further in the direction opposite to the first direction relative to the second submount 30B.

In this manner, by using the plurality of wires 60 while arranging the plurality of wires 60 so that they do not interfere with other wires 60, it is possible to achieve a stable wire connection while densely disposing the plurality of semiconductor laser elements 20.

The plurality of wires 60 include a plurality of seventh wires 60G that electrically connect the two submounts 30 disposed adjacent to each other. The plurality of seventh wires 60G include a seventh wire 60G that electrically connects the first submount 30A and the second submount 30B disposed adjacent to each other, and the seventh wire 60G that electrically connects the second submount 30B and the third submount 30C disposed adjacent to each other.

In the light-emitting device 1, the optical member 70 is joined to the package 10. The lower surface 71B of the optical member 70 faces the upper surface 14A of the package 10. The optical member 70 and the package 10 are joined by means of an adhesive.

The light reflected by the reflective member 40 is emitted from the upper surface 14A of the package 10 and impinges on the optical member 70. The light incident on the optical member 70 undergoes an optical action of the optical action surface and is then emitted from the optical member 70. For example, collimated light is emitted from the light-emitting device 1.

### Second Embodiment

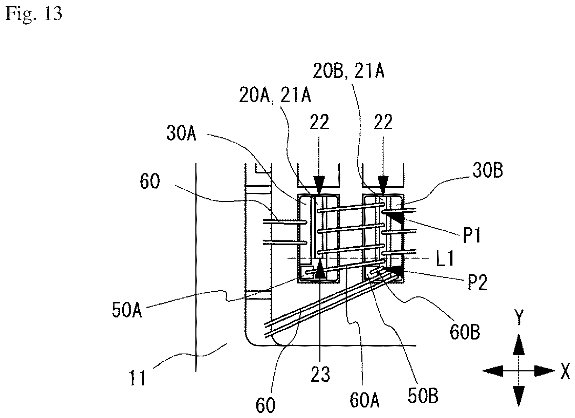

A light-emitting device 2 according to the second embodiment will now be described. FIGS. 1 to 4 and FIGS. 7 to 13 are diagrams for describing exemplary forms of the light-emitting device 2. FIG. 1 is a schematic perspective view of the light-emitting device 2. FIG. 2 is a schematic side view of the light-emitting device 2. FIG. 3 is a schematic top view of the light-emitting device 2. FIG. 4 is a schematic sectional view of the light-emitting device 2 taken along line IV-IV of FIG. 3. FIG. 7 is a schematic sectional view of the package 10 of the light-emitting device 2. Note that, the schematic sectional view of FIG. 7 corresponds to the cross section taken along line IV-IV of FIG. 3. FIG. 8 is a schematic top view of the base 11 of the light-emitting device 2. FIG. 9 is a schematic bottom view of the base 11. FIG. 10 is a schematic sectional view of the base 11. Note that, the schematic sectional view of FIG. 10 corresponds to the cross section taken along line IV-IV of FIG. 3. FIG. 11 is a schematic view of the semiconductor laser element 20 and the protective element 50 disposed on the submount 30. FIG. 12 is a schematic top view illustrating an internal structure of the light-emitting device 2. FIG. 13 is a schematic enlarged view for describing an aspect of wire connection of the light-emitting device 2.

All the contents of the explanation regarding the light-emitting device 1 and its components of the first embodiment, except for those that can be said to contradict

FIGS. 1 to 4 and FIGS. 7 to 13 related to the light-emitting device 2, also apply to the explanation of the light-emitting device 2. All non-contradictory contents will not be repeated here in order to avoid duplication.

### Light-Emitting Device 2

The light-emitting device 2 is different from the light-emitting device 1 in that the orientation of the electrode of the semiconductor laser element 20 is reversed. When it is assumed that a first electrode is provided at the upper surface 21A of the semiconductor laser element 20 and a second electrode is provided at the lower surface 21B in the light-emitting device 1, a second electrode is provided at the upper surface 21A of the semiconductor laser element 20 and a first electrode is provided at the lower surface 21B in the light-emitting device 2. In this manner, a light-emitting device can be achieved even in a case in which the orientation of the pn-junction in the semiconductor laser element 20 is reversed.

In the light-emitting device 2, the first wire 60A is joined to the upper surface 21A of the second semiconductor laser element 20B. The position where the first wire 60A is joined to the upper surface 21A of the second semiconductor laser element 20B is located further in the first direction relative to the position where the second wire 60B is joined to the upper surface 21A of the second semiconductor laser element 20B. In top view, the first wire 60A is disposed such that it does not pass through the virtual straight line L1.

In the light-emitting device 2, one or more third wires 60C are joined to the upper surface 21A of the second semiconductor laser element 20B. In top view, when the upper surface 21A of the second semiconductor laser element 20B is divided into two regions by the virtual straight line L1, the one or more third wires 60C are joined to one region, and the first wire 60A is joined to the other region.

In the light-emitting device 2, the wire 60 that is joined to the first wiring part 12A1 is joined to the first submount 30A. The wire 60 that is joined to the second wiring part 12A2 is joined to the second submount 30B. The one or more fourth wires 60D are joined to the upper surface 21A of the third semiconductor laser element 20C.

In the light-emitting device 2, the first wire 60A or the third wire 60C electrically connects the first submount 30A and the second submount 30B disposed adjacent to each other. The fourth wire 60D electrically connects the second submount 30B and the third submount 30C disposed adjacent to each other.

Although each of the embodiments according to the present invention has been described above, the light-emitting device according to the present invention is not strictly limited to the light-emitting device in each of the embodiments. In other words, the present invention can be achieved without being limited to the outer shape or structure of the light-emitting device disclosed by each of the embodiments. The present invention can be applied without requiring all the components being provided. For example, in a case in which some of the components of the light-emitting device disclosed by the embodiments are not stated in the claims, the degree of freedom in design by those skilled in the art such as substitutions, omissions, shape deformations, and material changes is allowed for those components, and then it is specified that the invention stated in the claims is applied to those components.

### Industrial Applicability

The light-emitting devices described in the embodiments can be used in a projector. That is, the projector can be said to be one application to which the present invention is applied. Note that the present invention is not limited thereto, and can be used in various applications, such as lighting, exposure, on-vehicle headlights, backlights of head-mounted displays and other displays, and the like.

## Claims

1. A light-emitting device comprising:
a plurality of semiconductor laser elements including a first semiconductor laser element and a second semiconductor laser element, each of the plurality of semiconductor laser elements having an an upper surface and a light-emitting surface;
a plurality of protective elements including
a first protective element configured to protect the first semiconductor laser element and
a second protective element configured to protect the second semiconductor laser element; and
a plurality of wires including a first wire joined to the first protective element and a second wire joined to the second protective element, the plurality of wires being electrically connected to the plurality of semiconductor laser elements and the plurality of protective elements, wherein
the first wire is not joined to the first semiconductor laser element, and
the second wire is joined to the upper surface of the second semiconductor laser element.

2. The light-emitting device according to claim 1, wherein a length of the second semiconductor laser element in a resonator direction is larger than a length of the first semiconductor laser element in the resonator direction.

3. The light-emitting device according to claim 1 or 2, wherein the plurality of wires include a plurality of third wires joined to the upper surface of the first semiconductor laser element and a plurality of fourth wires joined to the upper surface of the second semiconductor laser element.

4. The light-emitting device according to claim 3, wherein the number of the plurality of third wires and the number of the plurality of fourth wires are the same.

5. The light-emitting device according to claim 3 or 4, wherein a distance from a position (P1) where the fourth wire is joined to the upper surface of the second semiconductor laser element to the light-emitting surface of the second semiconductor laser element is shorter than a distance from a position (P2) where the second wire is joined to the upper surface of the second semiconductor laser element to the light-emitting surface of the second semiconductor laser element.

6. The light-emitting device according to any one of claims 1 to 5, wherein
each of the plurality of semiconductor laser elements includes a first surface located on a side opposite to the light-emitting surface,
in a top view, a distance from the first protective element to the first surface of the first semiconductor laser element is shorter than a distance from the first protective element to the light-emitting surface of the first semiconductor laser element, and
in the top view, a distance from the second protective element to the first surface of the second semiconductor laser element is shorter than a distance from the second protective element to the light-emitting surface of the second semiconductor laser element.

7. The light-emitting device according to claim 6, wherein in the top view, a distance from the light-emitting surface of the first semiconductor laser element to the first protective element and a distance from the light-emitting surface of the second semiconductor laser element to the second protective element are the same.

8. The light-emitting device according to any one of claims 1 to 7, further comprising a package in which the plurality of semiconductor laser elements is disposed, wherein
the package includes a plurality of wiring parts, each of the plurality of wiring parts being joined to one or more wires of the plurality of wires,
the plurality of wiring parts include a first wiring part and a second wiring part,
the first wire is joined to the first wiring part, and
a distance from the first semiconductor laser element to the first wiring part is shorter than a distance from the second semiconductor laser element to the first wiring part.

9. The light-emitting device according to claim 8, wherein
the plurality of wires include a third wire joined to the upper surface of the first semiconductor laser element and a fourth wire joined to the upper surface of the second semiconductor laser element,
the third wire is joined to the first wiring part, and
the fourth wire is joined to the second wiring part.

10. The light-emitting device according to claim 9, wherein
a first position (P1) where the fourth wire is joined to the upper surface of the second semiconductor laser element is located further in a first direction relative to the first protective element,
a second position (P3) where the fourth wire is joined to the second wiring part is located further in a direction opposite to the first direction relative to the first protective element,
a third position (P4) where the first wire is joined to the first wiring part is located further in the first direction relative to the second position, and
a fourth position (P5) where the third wire is joined to the first wiring part is located further in the first direction relative to the third position.

11. The light-emitting device according to claim 10, further comprising a plurality of submounts including a first submount where the first semiconductor laser element and the first protective element are disposed and a second submount where the second semiconductor laser element and the second protective element are disposed, wherein
in a top view, the fourth wire extends across the first submount.

12. The light-emitting device according to claim 11, wherein in the top view, the fourth wire is joined to the upper surface of the second semiconductor laser element and the second wiring part such that a virtual straight line that passes through the second protective element and extends in a second direction perpendicular to the first direction passes through the fourth wire.

13. The light-emitting device according to claim 12, wherein
the package includes a first inner lateral surface and a second inner lateral surface that faces the first inner lateral surface,
in the top view, the plurality of semiconductor laser elements are arranged in the second direction between the first inner lateral surface and the second inner lateral surface,
the plurality of wiring parts further include a third wiring part and a fourth wiring part,
the first wiring part and the second wiring part are provided on the first inner lateral surface side of the package,
the third wiring part and the fourth wiring part are provided on the second inner lateral surface side of the package,
the plurality of semiconductor laser elements include one or more third semiconductor laser elements,
the second semiconductor laser element is disposed at a position separated from the first semiconductor laser element in the second direction,
the one or more third semiconductor laser elements are disposed at a position separated from the second semiconductor laser element in the second direction, and
the plurality of wires include one or more fifth wires joined to the third wiring part and one or more sixth wires joined to the fourth wiring part.
